Europäisches Patentamt

European Patent Office

Office européen des brevets

(11) Veröffentlichungsnummer: **0 243 771 B1**

(12) **EUROPÄISCHE PATENTSCHRIFT**

(45) Veröffentlichungstag der Patentschrift: **23.09.92**

(51) Int. Cl.⁵: **G01R 23/02**

(21) Anmeldenummer: **87105445.8**

(22) Anmeldetag: **13.04.87**

(54) Verfahren und Anordnung zur schnellen und präzisen Messung der Frequenz eines Signals.

(30) Priorität: **26.04.86 DE 3614272**

(43) Veröffentlichungstag der Anmeldung:
**04.11.87 Patentblatt 87/45**

(45) Bekanntmachung des Hinweises auf die
Patenterteilung:
**23.09.92 Patentblatt 92/39**

(84) Benannte Vertragsstaaten:
**AT CH DE ES FR GB IT LI SE**

(56) Entgegenhaltungen:
**DE-A- 2 735 785**
**US-A- 4 443 766**

(73) Patentinhaber: **Blaupunkt-Werke GmbH**
**Robert-Bosch-Strasse 200**
**W-3200 Hildesheim(DE)**

(72) Erfinder: **Henze, Walter**
**Harzer Weg 5**
**W-3053 Hohnhorst(DE)**

(74) Vertreter: **Eilers, Norbert, Dipl.-Phys.**
**Blaupunkt-Werke GmbH Robert-**
**Bosch-Strasse 200**
**W-3200 Hildesheim(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung geht aus von einem Verfahren nach der Gattung des Anspruchs 1.

Es ist schon ein Verfahren zur Messung der Frequenz eines Signals bekannt, bei welchem Perioden des Signals über einen vorgegebenen Zeitabschnitt gezählt werden und das Ergebnis auf eine Sekunde umgerechnet wird. Dieses Verfahren kann jedoch nicht bei Signalen angewendet werden, deren Frequenz sich laufend ändert, es sei denn, man möchte die mittlere Frequenz messen.

Aus der DE-A-27 35 785 ist es zur Messung des arithmetischen Mittelwertes der Frequenz eines Signals bekannt, Triggerimpulse aus dem Signalverlauf abzuleiten und diese in einem Schieberegister zu speichern. Die Anzahl der besetzten Registerzellen erlaubt eine Aussage über die mittlere Frequenz im Verhältnis zu der Taktfrequenz, mit der die Triggerimpulse durch das Schieberegister hindurchgeschoben werden. Die zu messende Frequenz kann hierbei den Wert der Taktfrequenz erreichen.

Es sind jedoch auch Verfahren bekannt geworden, bei denen durch Zählung von Impulsen die Periodendauer des Signals bestimmt wird. Um eine genügend hohe Auflösung des Ergebnisses zu erhalten, benötigt man hierfür Zählimpulse, deren Frequenz wesentlich höher als die zu messende Frequenz ist. Insbesondere bei der hochauflösenden Messung von frequenzmodulierten Zwischenfrequenzsignalen ergeben sich für die bekannten Verfahren Werte, welche sich nicht mit bekannten Bauelementen realisieren lassen. Wollte man beispielsweise ein derartiges Signal in der Zwischenfrequenzebene (10,7 MHz) mit einer Genauigkeit von 12 Bit erfassen, müßte man für die letzte Stelle eine Periodendauerdifferenz von 0,32 ps erfassen können. Ein Meßverfahren, das diese Genauigkeit erreicht, ist nicht realisierbar. Bei der geforderten Genauigkeit erreicht man auch bei einer Herabsetzung des Zwischenfrequenzsignals in das Basisband keine realisierbaren Werte. Als Zählfrequenz wären dazu mindestens 614,4 MHz erforderlich. Dieses kann ebenfalls aus den verschiedensten Gründen nicht verwirklicht werden.

Das erfindungsgemäße Verfahren mit den kennzeichnenden Merkmalen des Anspruchs 1 hat demgegenüber den Vorteil, daß eine Frequenzmessung des Zwischenfrequenzsignals mit extrem hoher Auflösung unter Benutzung verfügbarer elektronischer Bauelemente möglich ist. Das erfindungsgemäße Verfahren ist nicht auf die Messung von Zwischenfrequenzsignalen beschränkt, sondern kann im Rahmen des Fachmännischen auch für andere Signale verwendet werden. Es hat zudem den Vorteil, daß der Meßwert digital als Ausgangswert zur Verfügung steht und so eine digitale Weiterverarbeitung des Signals erlaubt.

Durch die in den Unteransprüchen aufgeführten Maßnahmen sind vorteilhafte Weiterbildungen und Verbesserungen des erfindungsgemäßen Verfahrens möglich. Schaltungsanordnungen zur Durchführung des erfindungsgemäßen Verfahrens sind in den Ansprüchen 4 bis 9 aufgeführt.

Ein Ausführungsbeispiel der Erfindung ist in der Zeichnung an Hand mehrerer Figuren dargestellt und in der nachfolgenden Beschreibung näher erläutert.

Es zeigt:

Fig. 1      ein Blockschaltbild einer Schaltungsanordnung zur Durchführung des erfindungsgemäßen Verfahrens, welches wegen seines Umfangs auf Figuren 1a und 1b verteilt ist,

Fig. 2      ein Blockschaltbild eines in der Schaltungsanordnung nach Fig. 1 verwendeten Impulsformers,

Fig. 3      schematische Darstellungen zur Zuordnung der Ausgänge der Impulsformer zu Eingängen von ODER-Schaltungen innerhalb der Schaltungsanordnung nach Fig. 1,

Fig. 4      ein Blockschaltbild eines bei der Schaltungsanordnung nach Fig. 1 verwendeten Frequenz-und Phasenkomparators und

Fig. 5      Diagramme der bei dem Frequenz- und Phasenkomparators nach Fig. 4 auftretenden Signale.

Gleiche Teile sind in den Figuren mit gleichen Bezugszeichen versehen.

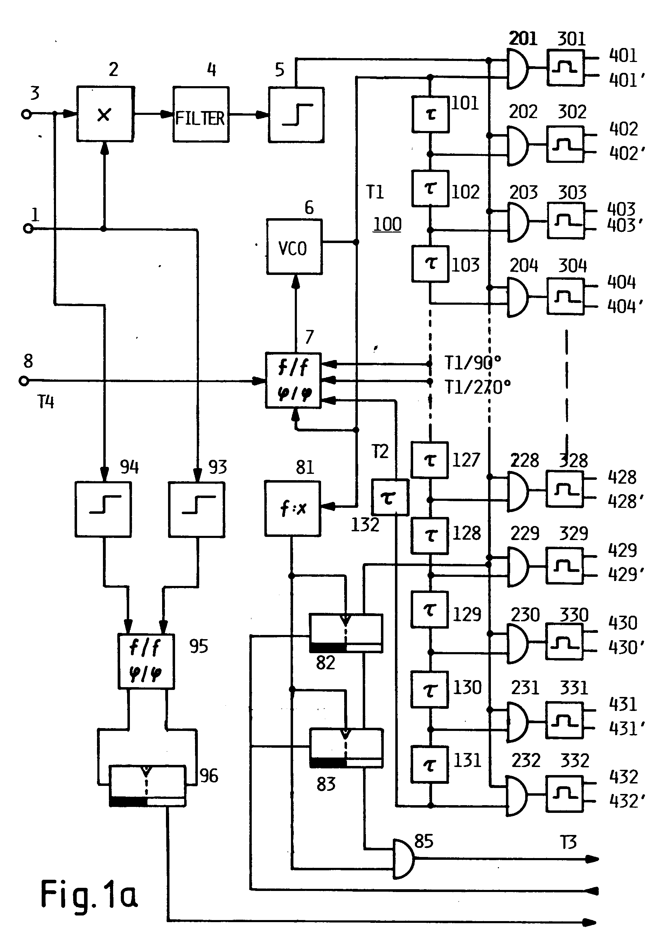

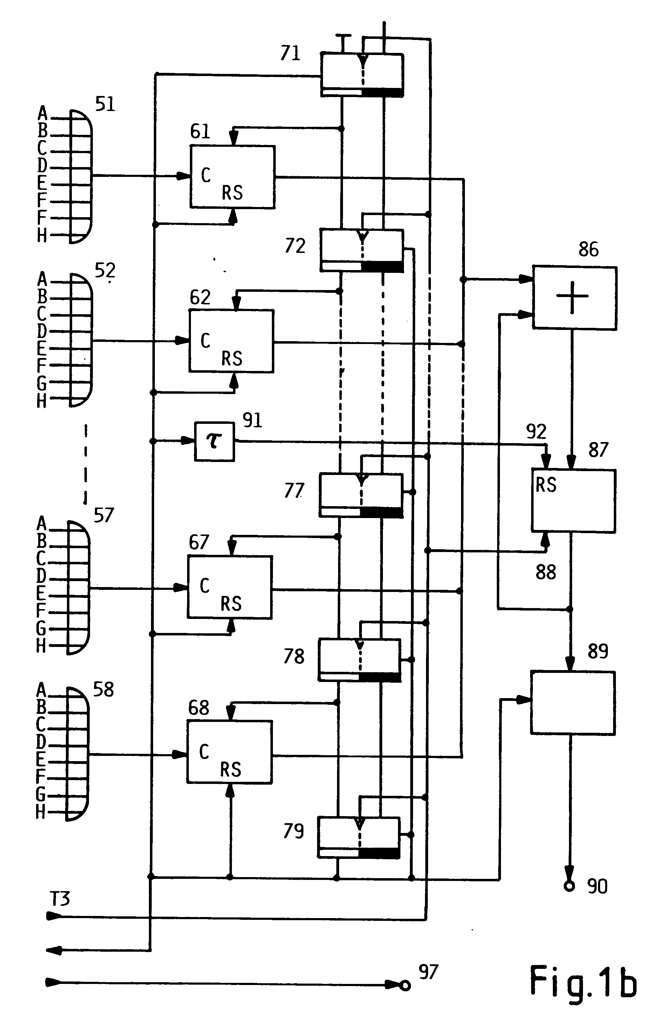

Der Schaltungsanordnung nach Fig. 1 wird bei 1 ein frequenzmoduliertes Zwischenfrequenzsignal zugeführt, welches in einer Mischschaltung mit einem ZF-Träger, der bei 3 zugeführt wird, gemischt wird. Mit Hilfe eines an die Mischschaltung 2 angeschlossenen Filters 4 wird aus dem Mischprodukt das Basisband, welches beim UKW-Rundfunk eine Bandbreite von 150 kHz hat, herausgefiltert. Dieses wird einem Begrenzer 5 zugeleitet, an dessen Ausgang ein rechteckförmiges Signal anliegt, dessen Frequenz dem jeweiligen Hub des frequenzmodulierten Signals entspricht.

Die Erzeugung von Taktimpulsen T1 erfolgt bei der Schaltungsanordnung nach Fig. 1 mit Hilfe eines steuerbaren Oszillators (VCO) 6, der von einem Frequenz- und Phasenkomparator 7 steuerbar ist. Dem Frequenz- und Phasenkomparator 7 wird bei 8 ein Taktsignal T4 mit einer Referenzfrequenz zugeführt. Die Frequenz der vom steuerbaren Oszillator 6 abgegebenen Taktimpulse T1 beträgt 15,625 MHz. Die Taktimpulse werden über eine Laufzeitkette 100 geleitet, welche aus 32 Gliedern 101 bis 132 besteht. Ein Glied verzögert die Taktimpulse um jeweils 2 ns. Der Takt T1 und die Taktimpulse, welche die gesamte Verzögerungskette 100 durchlaufen haben, werden dem Frequenz- und Phasenkomparator 7 zugeführt.

In später genauer beschriebener Weise wird durch Vergleich der verzögerten Taktimpulse T2 und der Taktimpulse T1 der steuerbare Oszillator 6 derart gesteuert, daß die Periodendauer der Taktimpulse T1 genau dem 32-fachen der Verzögerung eines Gliedes 101 bis 132 entspricht. An den Anzapfungen der Laufzeitkette 100 einschließlich deren Eingang und deren Ausgang stehen somit Impulse an, welche jeweils um 2 ns zueinander verzögert sind. Diese Impulse werden je einem Eingang einer der UND-Schaltungen 201 bis 232 zugeführt.

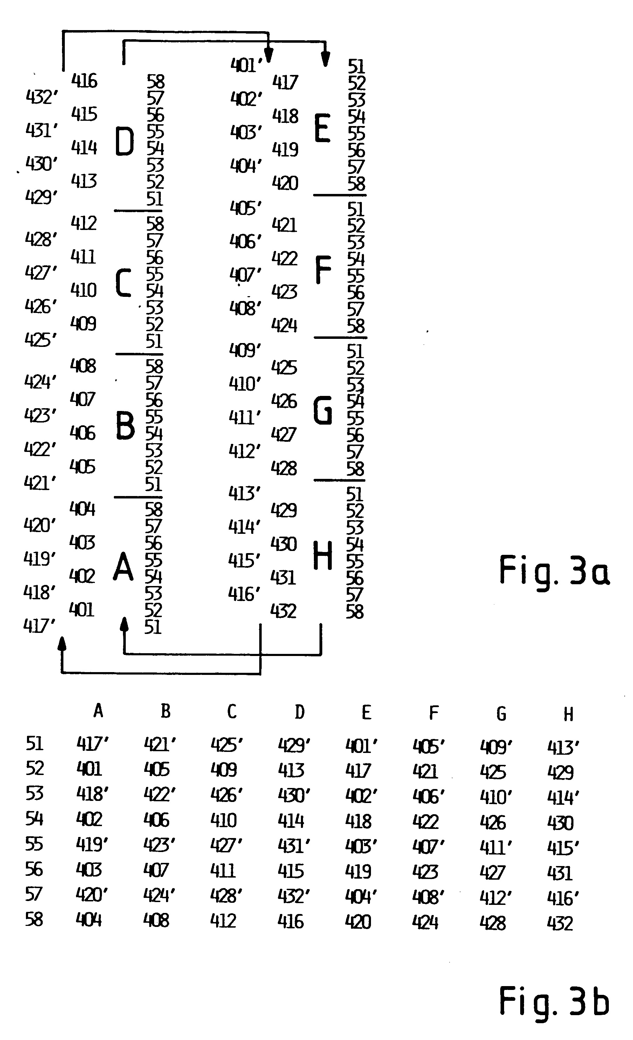

Den anderen Eingängen der UND-Schaltungen 201 bis 232 wird das Ausgangssignal des Begrenzers 5 zugeführt. An die Ausgänge der UND-Schaltungen 201 bis 232 ist je ein Impulsformer 301 bis 332 angeschlossen. Diese weisen jeweils zwei Ausgänge auf, an denen als Folge eines Eingangsimpulses zwei zeitlich versetzte Ausgangsimpulse auftreten. Da die Taktimpulse T1 mäanderförmig sind, tritt somit abwechselnd an den beiden Ausgängen jedes Impulsformers 301 bis 332 im Abstand von 32 ns ein Impuls auf - und zwar solange, wie am Ausgang des Begrenzers 5 die positive Halbwelle des Rechtecksignals ansteht. In den Figuren 1 und 3 sind die Ausgänge der Impulsformer 301 bis 332 mit 401 bis 432 sowie 401′ bis 432′ bezeichnet.

Wegen der hohen Frequenz aller Ausgangsimpulse der Impulsformer 301 bis 332 zusammengenommen werden zur Zählung der gesamten Anzahl der Impulse acht Zähler 61 bis 68 benötigt. Dabei erfolgt die Zuordnung der Takteingänge der Zähler zu den Ausgängen der Impulsformer 401 bis 432 über ODER-Schaltungen 51 bis 58, welche jeweils acht Eingänge A bis H aufweisen. Die Verteilung der Zählimpulse 401 bis 432′ erfolgt nach dem in Fig. 3 dargestellten Schema auf die Eingänge A bis H der ODER-Schaltungen 51 bis 58. Die Aufteilung ist derart vorgenommen, daß die Zählimpulse an den Eingängen A bis H eines ODER-Gatters zeitlich immer den gleichen Abstand haben und nicht zu dicht aufeinander folgen, so daß die Taktgrenzfrequenz des nachfolgenden Zählers nicht überschritten wird. Durch eine größere Zahl von ODER-Schaltungen und Zählern können auch Zähler verwendet werden, welche nur für geringere Taktfrequenzen geeignet sind.

Nachdem die Periodendauerzählung beendet ist - das Ausgangssignal des Begrenzers 5 ist dann gleich 0 -, ist der Meßwert aus allen Zählerständen zu bilden. Dazu hat in möglichst kurzer Zeit eine Summenbildung aller Zählerstände zu erfolgen. Mittels eines Schieberegisters, das aus den Flip-Flops 71 bis 79 besteht und zu Beginn der Aufsummierung auf den Wert 1 gesetzt wurde, werden nacheinander die Zählerstände zu einem Addierer durchgeschaltet. Dazu sind die Ausgänge der Flip-Flops 71 bis 79 mit Ausgangsregistern der Zähler 61 bis 68 verbunden. Die Ausgänge der Zähler sind im durchgeschalteten Zustand niederohmig und anderenfalls hochohmig.

Das Taktsignal T3 für das Schieberegister 71 bis 79 wird mit dem Frequenzteiler 81 aus den Taktimpulsen T1 gewonnen. Sobald das begrenzte frequenzmodulierte Zwischenfrequenzsignal 0 geworden ist, wird das Flip-Flop 82 gesetzt. Danach wird mit dem nächsten Taktimpuls T3 auch das Flip-Flop 83 gesetzt und damit der Takt für das Schieberegister 71 bis 79 über die UND-Schaltung 85 freigegeben.

Mit der positiven Flanke des Schiebetaktes T3 wird der jeweilige Zählerstand zum Addierer 86 durchgeschaltet und mit jeder negativen Flanke des Schiebetaktes das Ergebnis des Addierers 86 in einen Summenspeicher 87 übernommen, wozu das Taktsignal T3 den Steuereingang 88 eines Eingangsregisters des Summenspeichers 87 zugeführt wird. Das so in dem Summenspeicher 87 festgehaltene Zwischenergebnis wird bei der nächsten Addition wieder als ein Summand verwendet.

Das letzte Flip-Flop 79 des Schieberegisters schaltet keinen Zählerstand zum Addierer 86 mehr durch, sondern beendet die Summenbildung, indem es das Schieberegister 71 bis 79 wieder auf den Wert 1 setzt, die beiden Flip-Flops 82, 83 sowie die Zähler 61 bis 68 rücksetzt und den Wert des Summenspeichers 87 in einen Ausgabespeicher 89 überträgt. Am Ausgang 90 des Ausgabespeichers steht dann das Meßergebnis in digitaler Form zur Verfügung.

Nach erfolgter Übertragung des Meßergebnisses aus dem Summenspeicher 87 in den Ausgabespeicher 89 wird der Summenspeicher 87 ebenfalls gelöscht. Hierzu wird vom Ausgang des Flip-Flops 79 über eine Verzögerungsschaltung 91 einem Rücksetzeingang 92 des Summenspeichers 87 ein entsprechendes Signal zugeführt.

Die Werte im Ausgabespeicher sind dem FM-Frequenzhub umgekehrt proportional und werden durch Kehrwertbildung in Werte umgerechnet, welche der Frequenz proportional sind. Da bei der Messung des Frequenzhubs, also der momentanen Abweichung der Frequenz des modulierten Signals vom zugehörigen Träger auch das Vorzeichen dieser Differenz von Bedeutung ist, wird - wie im folgenden beschrieben - ein Vorzeichenbit abgeleitet. Dazu wird sowohl der Träger als auch das frequenzmodulierte Signal über je einen Begrenzer 93, 94 einem weiteren Frequenz- und Phasenkomparator 95 zugeführt, mit dessen beiden Ausgangssignalen ein Flip-Flop 96 gesteuert wird, an dessen Ausgang 97 das Vorzeichenbit abgreifbar ist.

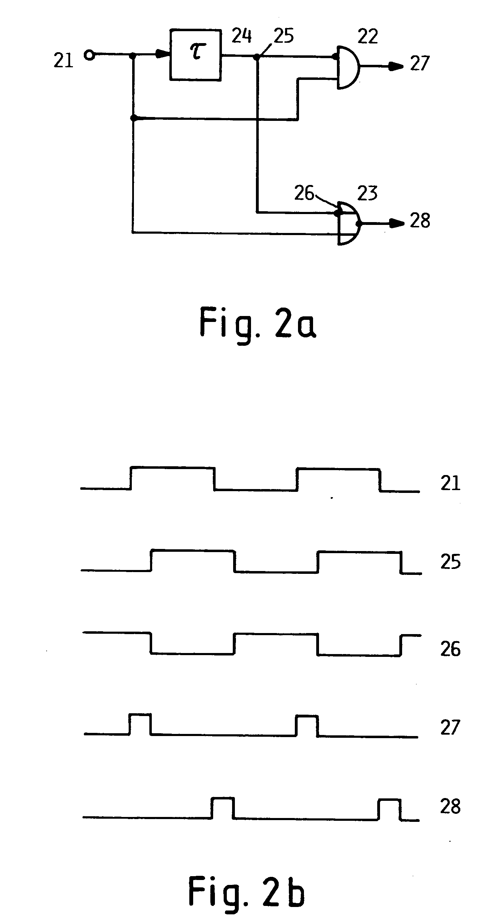

Im folgenden werden an Hand von Fig. 2 die Impulsformer 301 bis 332 erläutert. Dabei stellen Fig. 2a ein Blockschaltbild eines der Impulsformer und Fig. 2b Diagramme der auftretenden Signale dar. Die einzelnen Zeilen in Fig. 2b sind mit den gleichen Bezugszeichen versehen wie die Schaltungspunkte in Fig. 2a, an welchen die dargestellten Signale auftreten.

Der Eingang 21 des Impulsformers ist an den Ausgang einer der UND-Schaltungen 201 bis 232 (Fig. 1a) angeschlossen und empfängt die in Fig. 2b in Zeile 21 dargestellten mäanderförmige Impulse. Diese werden je einem Eingang einer UND-Schaltung 22 und einer ODER-Schaltung 23 zugeführt. Außerdem werden sie von einer Verzögerungsschaltung 24 um einen Bruchteil der Periodendauer verzögert.

Die verzögerten mäanderförmigen Signale sind in Zeile 25 der Fig. 2b dargestellt und werden jeweils einem invertierenden Eingang der UND-Schaltung 22 und der NOR-Schaltung 23 zugeleitet. Das invertierte Signal ist in Fig. 2b, Zeile 26 gezeigt. Durch die UND-Verknüpfung der Signale nach Zeile 21 und Zeile 26 ergeben sich die in Zeile 27 gezeigten Impulse. Durch die NOR-Verknüpfung der gleichen Signale entstehen die in Zeile 28 gezeigten Impulse.

Durch die Aufteilung der Ausgangsimpulse der UND-Schaltungen 201 bis 232 (Fig. 1a) in jeweils zwei zeitlich um eine halbe Periodendauer gegeneinander versetzte Impulse wird eine Verdopplung der Anzahl der Zählimpulse und damit eine Verdopplung der Genauigkeit erzielt. Dieses setzt jedoch eine geeignete Verschachtelung aller von den Impulsformern 301 bis 332 abgegebenen Impulse voraus. Dabei ist zu berücksichtigen, daß die Zeitverzögerung von einer Anzapfung der Laufzeitkette 100 zur nächsten nur 2 ns beträgt, daß sich jedoch die Zeitdifferenz zwischen den Impulsen an den oberen Ausgängen der Impulsformer und den Impulsen an den unteren Ausgängen auf 32 ns beläuft.

Die Reihenfolge des Auftretens der einzelnen Zählimpulse ist in Fig. 3a schematisch dargestellt. Zusätzlich sind den Zählimpulsen die Eingänge A bis H der in Fig. 1b dargestellten ODER-Schaltungen 51 bis 58 gegenübergestellt. In einem durch Pfeile markierten Umlauf sind die Zählimpulse der Ausgänge 401 bis 432 enthalten, während in einem zweiten Umlauf, der mit gleicher Frequenz durchlaufen wird, die Eingänge der ODER-Gatter dargestellt sind.

Die in Fig. 3b wiedergegebene Tabelle zeigt noch einmal die Zuordnung der Ausgänge der Impulsformer 301 bis 332 zu den Eingängen der ODER-Schaltungen 51 bis 58.

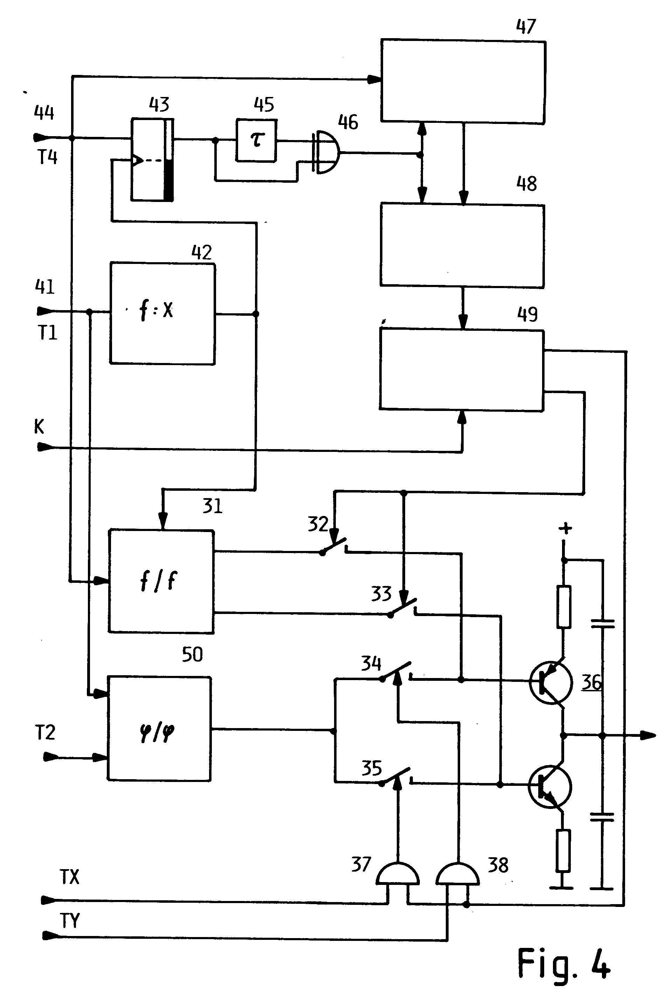

Fig. 4 zeigt ein Blockschaltbild des Frequenz- und Phasenkomparators 7 (Fig. 1a). Um zu erreichen, daß der steuerbare Oszillator 6 (Fig. 1) auf einer Frequenz schwingt, bei welcher der Ausgangstakt T1 mit der gesamten Laufzeitkette 100 genau um eine Periodendauer verzögert wird, wird zunächst (nach dem Einschalten) mit einem Frequenzkomparator die gewünschte Frequenz eingestellt. Anschließend wird mit einem schnellen Phasenkomparator die Phase am Eingang und am Ausgang der Laufzeitkette auf 0° bzw. 360° geregelt. Dabei wird laufend geprüft, ob die Regelung des steuerbaren Oszillators mit dem Frequenzkomparator oder mit dem Phasenkomparator zu erfolgen hat.

Dazu wird das vom steuerbaren Oszillator 6 erzeugte Signal T1 über den Eingang 41 der Schaltung nach Fig. 2 zugeführt und gelangt in einen Frequenzteiler 42.

Das Ausgangssignal des Frequenzteilers 42 wird in einem D-Flip-Flop 43 mit einem bei 44 zugeführten Referenzsignal T4 gemischt. Am Ausgang des D-Flip-Flops 43 steht ein Signal mit der Differenzfrequenz zur Verfügung. Aus jeder positiven und negativen Flanke dieses Signals wird mit Hilfe der Verzögerungsschaltung 45 und der EXCL-ODER-Schaltung 46 ein kurzer Impuls abgeleitet, der den Zählerstand eines Zählers 47 in einen Speicher 48 übernimmt und den Zähler 47 anschließend rücksetzt. Der Zähler 48 zählt die Takte des Referenzsignals T4 jeweils zwischen benachbarten Impulsen am Ausgang des EXCL-ODER-Gatters 46. Der Zähler 48 zählt bis zu einem oberen Grenzwert, womit ein Überlauf verhindert wird. In einem Komparator 49 wird der Inhalt des Speichers 48 mit einem vorgegebenen Wert K verglichen. Wenn der Inhalt des Speichers 48 kleiner ist als der Wert K, dann wird der Frequenzkomparator 31 eingeschaltet, wobei die Schalter 32 und 33 dann leitend sind, während die Schalter 34 und 35 nichtleitend sind. Ansonsten wird der Phasenkomparator 50 benutzt.

Weil die Phasenregelung sehr schnell und genau sein muß, wird ein Differenzverstärker als Phasenkomparator 50 verwendet, dessen Ausgangssignal bei übereinstimmender Phasenlage 0 V und bei Abweichungen zwischen den Taktsignalen T1 und T2 positiv oder negativ ist. Über eine Ausgangsstufe 36 wird die Steuerspannung dem steuerbaren Oszillator 6 (Fig. 1a) zugeleitet.

Die Laufzeitkette 100 enthält Anzapfungen, bei denen die Phasendrehung des Signals T1 bei Vorliegen der Sollfrequenz 90° bzw. 270° beträgt. Diese Signale T1/90° und T1/270° bestimmen nach UND-Verknüpfungen mit dem Ausgangssignal des Phasenkomparators 50 (Fig. 4) bei der Schaltungsanordnung nach Fig. 4 über die UND-Gatter 37 und 38, wann die Schalter 34 und 35 geschlossen werden, unter der Voraussetzung, daß vom Komparator 49 ein entsprechendes Signal den anderen Eingängen der UND-Schaltungen 37 und 38 zugeführt wird, welches besagt, daß die Frequenzen der Signale T1 und T4 nur geringfügig voneinander abweichen.

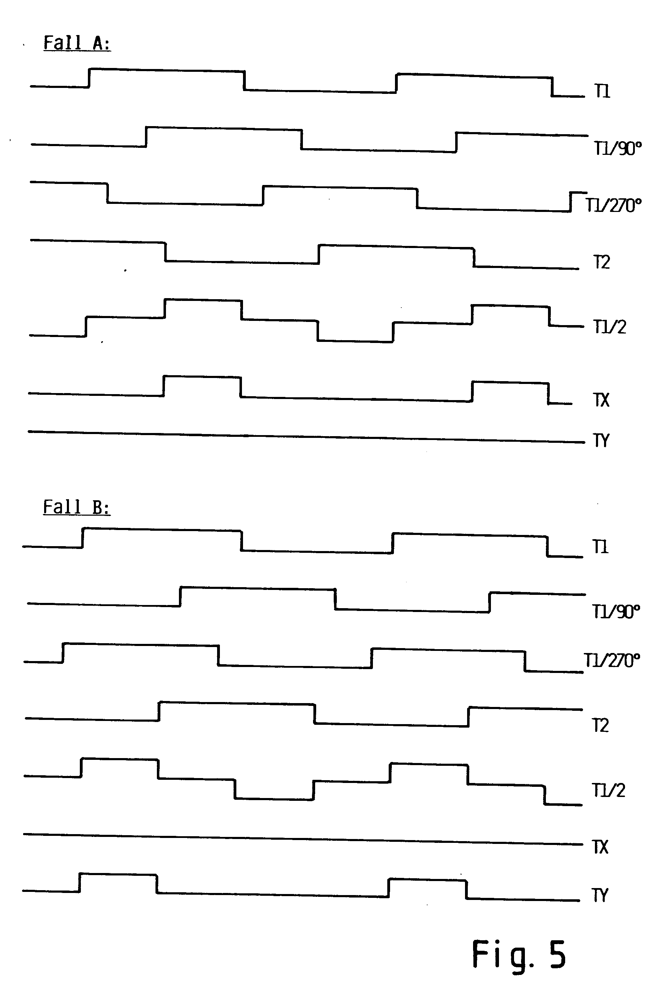

Zur weiteren Erläuterung der Schaltungsanordnung nach Fig. 4 sind in Fig. 5 Signale, welche in der Schaltungsanordnung auftreten, dargestellt. Sie sind gleichlautend mit denjenigen Punkten der Schaltungsanordnung bezeichnet, an welchen sie auftreten. Die Signale sind für zwei Fälle dargestellt. Im Fall A ist nämlich die Gesamtverzögerung der Laufzeitkette zugering und im Fall B ist die Gesamtverzögerung zu groß.

Das Signal T1/2 ist das Ausgangssignal eines Differenzverstärkers, der als Phasenkomparator 50 (Fig. 4) arbeitet. Die Ausgangsspannung ist negativ, wenn T1 kleiner als T2 ist, Null, wenn T1 gleich T2 ist, und positiv, wenn T1 größer als T2 ist. Das Signal T1/2 wird nun mit den Signalen T1/90° und T1/270° UND-verknüpft, wobei die negativen Werte von T1/2 zu Null gesetzt werden. Es entstehen die Signale T1/2 + T1/90° abgekürzt TX und T1/2 + T1/270° abgekürzt TY, mit denen die Gatter 37 und 38 (Fig. 4) angesteuert werden.

**Patentansprüche**

1. Verfahren zur Messung der Frequenz eines Signals, wobei aus Taktimpulsen abgeleitete Zählimpulse gezählt werden und das Zählergebnis als digitales Signal ausgegeben wird, dadurch gekennzeichnet, daß die Frequenz der Zählimpulse einem Vielfachen der Frequenz der Taktimpulse entspricht, daß die Zählimpulse an verschiedenen Anzapfungen einer Laufzeitkette (101 bis 132) auftreten, daß das Signal in einem Begrenzer (5) derart begrenzt wird, daß während einer Halbwelle des Signals das Ausgangssignal des Begrenzers (5) größer Null ist, daß die Zählimpulse mit Hilfe von mehreren Zählern (61 bis 68) während einer Halbwelle gezählt werden und daß nach Ablauf dieser Halbwelle des Signals die Inhalte der Zähler (61 bis 68) zusammengefaßt und mittels Kehrwertbildung in die entsprechende Frequenzangabe umgesetzt werden.

2. Verfahren nach Anspruch 1, dadurch gekennzeichnet, daß zur Messung der Frequenz eines frequenzmodulierten Signals dieses in einem Mischer (2) mit einem zugehörigen Träger gemischt wird.

3. Verfahren nach Anspruch 2, dadurch gekennzeichnet, daß durch Frequenz- und Phasenvergleich des in einem zweiten Begrenzer (93) amplitudenbegrenzten frequenzmodulierten Signals mit einem in einem dritten Begrenzer (94) amplitudenbegrenzten Träger in einem Komparator (95) ein Vorzeichensignal gewonnen wird.

4. Schaltungsanordnung zur Durchführung des Verfahrens nach Anspruch 1, dadurch gekennzeichnet, daß der Ausgang eines zur Erzeugung der Taktimpulse vorgesehenen Oszillators (6) an den Eingang der Laufzeitkette (100) angeschlossen ist, daß die Laufzeitkette (100) n Glieder (101 bis 132) aufweist, wobei n dem Verhältnis zwischen den Frequenzen der Zählimpulse und der Taktimpulse entspricht, daß der Eingang der Laufzeitkette (100) sowie die zwischen den Gliedern (101 bis 132) liegenden Anzapfungen mit einem ersten Eingang je einer UND-Schaltung (201 bis 232) verbunden sind, daß zweite Eingänge der UND-Schaltungen (201 bis 232) mit einer rechteckförmigen Spannung beaufschlagt sind, welche die Frequenz des zu messenden Signals aufweist, daß die Ausgänge der UND-Schaltungen (201 bis 232) über ODER-Schaltungen (51 bis 58) mit Eingängen von Zählern (61 bis 68) verbunden sind, deren Ausgänge mit einer Addier- und Speicherschaltung (86, 87, 89) verbunden sind.

5. Schaltungsanordnung nach Anspruch 4, dadurch gekennzeichnet, daß zwischen die Ausgänge der UND-Schaltungen (201 bis 232) und Eingänge der ODER-Schaltungen (51 bis 58) jeweils Impulsformer (301 bis 332) geschaltet sind, die an einem ersten Ausgang (401 bis 432) von den Vorderflanken der zugeführten Impulse ausgelöste Impulse und an einem zweiten Ausgang (401' bis 432') von den Rückflanken ausgelöste Impulse abgeben.

6. Schaltungsanordnung nach Anspruch 4, dadurch gekennzeichnet, daß die Frequenz des Oszillators (6) mit Hilfe eines Frequenzkomparators (31) und eines Phasenkomparators (50) steuerbar ist, daß dem Frequenzkomparator (31) die Taktimpulse und ein Signal mit einer Referenzfrequenz zugeführt sind, daß dem Phasenkomparator (50) die Taktimpulse jeweils vom Ausgang des Oszillators (6) und vom Ausgang der Laufzeitkette (100) zugeführt sind und

daß eine Umschalteinrichtung (32 bis 35, 42 bis 49) vorgesehen ist, welche in Abhängigkeit davon, ob die Differenz zwischen der Referenzfrequenz und der Taktfrequenz einen vorgegebenen Wert unterschreitet, vom Frequenzkomparator (31) auf den Phasenkomparator (50) umschaltet.

7. Schaltungsanordnung nach Anspruch 4,
dadurch gekennzeichnet,
daß Ausgänge der Zähler (61 bis 68) über einen zyklischen Umschalter mit der Addier- und Speicherschaltung (86, 87, 89) verbunden sind,
daß dem Umschalter Umschaltimpulse von einem Frequenzteiler (81) über eine Torschaltung (82 bis 85) zuführbar sind, wobei der Eingang des Frequenzteilers (81) an den Ausgang des Oszillators (6) angeschlossen ist, und
daß die Torschaltung (82 bis 85) derart steuerbar ist, daß nach Ablauf eines auszählenden Zeitabschnitts Umschaltimpulse dem Umschalter zugeführt werden und daß die Zuführung der Umschaltimpulse unterbleibt, wenn der Umschalter einen Umschaltzyklus vollendet hat.

8. Schaltungsanordnung nach Anspruch 7,
dadurch gekennzeichnet,
daß der Umschalter von einem Schieberegister (71 bis 79) und Ausgangsregistern der Zähler (61 bis 68) gebildet ist,
daß die Umschaltimpulse dem Schieberegister als Takt zugeführt sind und
daß ein Ausgang eines der das Schieberegister (71 bis 79) bildenden Flip-Flops mit Rücksetzeingängen der Zähler des Schieberegisters und mit einem Steuereingang der Torschaltung (82, 83, 85) verbunden ist.

9. Schaltungsanordnung nach Anspruch 4,
dadurch gekennzeichnet,
daß die Addier- und Speicherschaltung (86, 87, 89) von einem Addierer (86), einem Summenspeicher (87) und einem Ausgabespeicher (89) gebildet ist,
daß ein Eingang des Addierers (86) über einen Umschalter mit den Ausgängen der Zähler (61 bis 68) und der andere Eingang des Addierers (86) mit einem Ausgang des Summenspeichers (87) verbunden ist,
daß an den Ausgang des Addierers (86) ein Eingang des Summenspeichers (87) angeschlossen ist und
daß der Ausgang des Summenspeichers (87) mit einem Eingang des Ausgabespeichers (89) verbunden ist.

**Claims**

1. Method of measuring the frequency of a signal, in which counting pulses derived from clock pulses are counted and the counting result is output as a digital signal, characterised in that the frequency of the counting pulses corresponds to a multiple of the frequency of the clock pulses, in that the counting pulses occur at various tapping points of a delay line (101 - 132), in that the signal is limited in a limiter (5) in such a way that, during a half-wave of the signal, the output signal of the limiter (5) is greater than zero, in that the counting pulses are counted during a half-wave with the aid of a plurality of counters (61 - 68) and in that, after expiry of this half-wave of the signal, the contents of the counters (61 - 68) are combined and converted by means of reciprocal-value formation into the corresponding frequency information.

2. Method according to Claim 1, characterised in that, for measuring the frequency of a frequency-modulated signal, the latter is mixed with an associated carrier in a mixer (2).

3. Method according to Claim 2, characterised in that an operational-sign signal is obtained by frequency and phase comparison in a comparator (95) of the frequency-modulated signal which has been amplitudelimited in a second limiter (93) with a carrier which has been amplitude-limited in a third limiter (94).

4. Circuit arrangement for carrying out the method according to Claim 1, characterised in that the output of an oscillator (6) provided for generating the clock pulses is connected to the input of the delay line (100), in that the delay line (100) has n elements (101 - 132), n corresponding to the ratio between the frequencies of the counting pulses and the clock pulses, in that the input of the delay line (100) as well as the tapping points lying between the elements (101 - 132) are connected to a first input each of an AND circuit (201 - 232), in that a square-wave voltage which has the frequency of the signal to be measured is applied to second inputs of the AND circuits (201 - 232), and in that the outputs of the AND circuits (201 - 232) are connected via OR circuits (51 - 58) to inputs of counters (61 - 68), the outputs of which are connected to an adding and storing circuit (86, 87, 89).

5. Circuit arrangement according to Claim 4, characterised in that pulse shapers (301 - 332) are connected in each case between the outputs of the AND circuits (201 - 232) and inputs of the OR circuits (51 - 58) and emit at a first output (401 - 432) pulses triggered by the leading edges of the fed pulses and at a second output (401' - 432') pulses triggered by the trailing edges.

6. Circuit arrangement according to Claim 4, characterised in that the frequency of the oscillator (6) can be controlled with the aid of a frequency comparator (31) and a phase comparator (50), in that the frequency comparator (31) is fed the clock pulses and a signal having a reference frequency, in that the phase comparator (50) is fed the clock pulses respectively from the output of the oscillator (6) and from the output of the delay line (100) and in that a switching-over device (32-35, 42-49) is provided, which switches over from the frequency comparator (31) to the phase comparator (50), dependent on whether the difference between the reference frequency and the clock frequency drops below a predetermined value.

7. Circuit arrangement according to Claim 4, characterised in that outputs of the counters (61 - 68) are connected via a cyclical change-over switch to the adding and storing circuit (86, 87, 89), in that the change-over switch can be fed switching pulses from a frequency divider (81) via a gate circuit (82 - 85), the input of the frequency divider (81) being connected to the output of the oscillator (6), and in that the gate circuit (82 - 85) can be controlled in such a way that, after expiry of a counting-out time period, switching pulses are fed to the change-over switch and in that the feeding of the switching pulses does not take place if the change-over switch has completed a switching cycle.

8. Circuit arrangement according to Claim 7, characterised in that the change-over switch is formed by a shift register (71 - 79) and output registers of the counters (61 - 68), in that the switching pulses are fed to the shift register as a clock and in that an output of one of the flip-flops forming the shift register (71 - 79) is connected to recessing inputs of the counters of the shift register and to a control input of the gate circuit (82, 83, 85).

9. Circuit arrangement according to Claim 4, characterised in that the adding and storing circuit (86, 87, 89) is formed by an adder (86), a sum memory (87) and an output memory (89), in that one input of the adder (86) is connected via a change-over switch to the outputs of the counters (61 - 68) and the other input of the adder (86) is connected to an output of the sum memory (87), in that an input of the sum memory (87) is connected to the output of the adder (86) and in that the output of the sum memory (87) is connected to an input of the output memory (89).

**Revendications**

1. Procédé de mesure de la fréquence d'un signal en comptant des impulsions de comptage dérivées d'impulsions d'horloge ou cadence et en émettant le résultat de comptage comme signal numérique, procédé caractérisé en ce que la fréquence des impulsions de comptage correspond à un multiple de la fréquence des impulsions d'horloge,
   - les impulsions de comptage apparaissant sur différentes prises d'une chaîne de temporisation (101-132),
   - le signal est limité dans un limiteur (50) pour que pendant une demi-onde du signal, le signal de sortie du limiteur (5) soit supérieur à zéro,
   - les impulsions de comptage sont comptées à l'aide de plusieurs compteurs (61-68) pendant une demi-onde et en ce qu'après cette demi-onde du signal, on réunit le contenu des compteurs (61-68) et on les transforme en une indication de fréquence appropriée en formant une valeur inverse.

2. Procédé selon la revendication 1, caractérisé en ce que pour mesurer la fréquence d'un signal modulé en fréquence, on mélange celui-ci dans un mélangeur (2) à une porteuse appropriée.

3. Procédé selon la revendication 2, caractérisé en ce que par comparaison de fréquence, et de phase du signal modulé en fréquence, limitée en amplitude dans un second limiteur (93), on déduit un signal de signe algébrique dans un comparaterur (95) par un troisième limiteur (94) à l'aide d'une porteuse limitée en amplitude.

4. Circuit pour la mise en oeuvre du procédé selon la revendication 1, caractérisé en ce que la sortie d'un oscillateur (6) générant l'impulsion d'horloge est reliée à l'entrée de la chaîne de temporisation (100),
   - la chaîne de temporisation (100) comprend n éléments (101-132), n correspondant au rapport entre les fréquences des impulsions de comptage et les impulsions d'horloge,

- l'entrée de la chaîne de temporisation (100) ainsi que les prises situées entre les éléments (101-132) sont respectivement reliées à une première entrée d'une porte ET (201-232),
- les secondes entrées des portes ET (201-232) reçoivent une tension rectangulaire qui correspond à la fréquence du signal à mesurer,
- les sorties des portes ET (201-232) sont reliées par des portes OU (51-58) aux entrées des compteurs (61-68) dont les sorties sont reliées à un circuit additionneur et de mise en mémoire (86, 87, 89).

5. Circuit selon la revendication 4, caractérisé en ce qu'entre les sorties des portes ET (201-232) et les entrées des portes OU (51-58), on a chaque fois un formeur d'impulsions (301-332) qui fournit à une première sortie (401-432) des impulsions déclenchées par le flanc avant des impulsions appliquées et à une seconde sortie (401'-432'), les impulsions déclenchées par les flancs arrière.

6. Circuit selon la revendication 4, caractérisé en ce que la fréquence de l'oscillateur (6) se commande à l'aide d'un comparateur de fréquence (31) et d'un comparateur de phase (50),

- le comparateur de fréquence (31) fournit les impulsions d'horloge et un signal à la fréquence de référence,
- le comparateur de phase (50) reçoit les impulsions d'horloge provenant respectivement de la sortie de l'oscillateur (6) et de la sortie de la chaîne de temps (100) et en ce qu'un circuit de commutation (31-35, 42-49) est prévu qui, en fonction de la différence entre la fréquence de référence et la fréquence d'horloge passant en-dessous d'une valeur prédéterminée, commute du comparateur de fréquence (31) sur le comparateur de phase (50).

7. Circuit selon la revendication 4, caractérisé en ce que les sorties des compteurs (61-68) sont reliées par un commutateur cyclique au circuit d'addition et de mise en mémoire (86, 87, 89),

- le commutateur reçoit les impulsions de commutation d'un diviseur de fréquence (81) par l'intermédiaire d'un montage à portes (82-85), l'entrée du diviseur de fréquence (81) étant reliée à la sortie de l'oscillateur (6) et,

- le circuit de porte (81-85) est commandé de façon qu'à la fin d'un intervalle de temps à décompter, des impulsions de commutation soient transmises au commutateur et en ce que la transmission des impulsions de commutation ne se fait pas lorsque le commutateur a terminé un cycle de commutation.

8. Circuit selon la revendication 7, caractérisé en ce que le commutateur est formé d'un registre à décalage (71-79) et des registres de sortie des compteurs (61-68),

- les impulsions de commutation sont appliquées au registre à décalage comme horloge et en ce qu'une sortie d'un flip-flop formant le registre à décalage (71-72) est reliée aux entrées de remise à l'état initial des compteurs du registre à décalage et à l'entrée de commande du circuit de porte (82, 83, 85).

9. Circuit selon la revendication 4, caractérisé en ce que le circuit d'addition et de mise en mémoire (86, 87, 89) est formé d'un additionneur (86), d'une mémoire d'addition (87) et d'une mémoire de sortie (89),

- une entrée de l'additionneur (86) étant reliée par un commutateur aux sorties du compteur (61-68) et l'autre entrée de l'additionneur (86) étant reliée à une sortie de la mémoire d'addition (87),
- la sortie de l'additionneur (86) est reliée à une entrée de la mémoire d'additionneur (87) et en ce que la sortie de la mémoire d'additionneur (87) est reliée à une entrée de la mémoire de sortie (89).

Fig.1a

Fig.1b

Fig. 2a

Fig. 2b

**Fig. 3a**

**Fig. 3b**

|    | A     | B     | C     | D     | E     | F     | G     | H     |
|----|-------|-------|-------|-------|-------|-------|-------|-------|
| 51 | 417'  | 421'  | 425'  | 429'  | 401'  | 405'  | 409'  | 413'  |
| 52 | 401   | 405   | 409   | 413   | 417   | 421   | 425   | 429   |
| 53 | 418'  | 422'  | 426'  | 430'  | 402'  | 406'  | 410'  | 414'  |
| 54 | 402   | 406   | 410   | 414   | 418   | 422   | 426   | 430   |
| 55 | 419'  | 423'  | 427'  | 431'  | 403'  | 407'  | 411'  | 415'  |
| 56 | 403   | 407   | 411   | 415   | 419   | 423   | 427   | 431   |
| 57 | 420'  | 424'  | 428'  | 432'  | 404'  | 408'  | 412'  | 416'  |
| 58 | 404   | 408   | 412   | 416   | 420   | 424   | 428   | 432   |

Fig. 4

Fall A:

Fall B:

Fig. 5